# EUROPEAN PATENT APPLICATION

(11) **EP 4 565 022 A1**
(43) Date of publication of application: **04.06.2025**
(21) Application number: 23863417.4
(22) Date of filing: 01.09.2023
(51) Int. Cl.: H05K 9/00, H04M 1/02

(54) **ELECTRONIC DEVICE INCLUDING SHIELD CAN**

(30) Priority: 07.09.2022 KR 20220113557; 17.10.2022 KR 20220133089
(71) Applicant: Samsung Electronics Co., Ltd., Suwon-si, Gyeonggi-do 16677 (KR)
(72) Inventor: KIM, Joosoon, Suwon-si Gyeonggi-do 16677 (KR); KIM, Hakjoon, Suwon-si Gyeonggi-do 16677 (KR); BANG, Jungje, Suwon-si Gyeonggi-do 16677 (KR); BAEK, Moohyun, Suwon-si Gyeonggi-do 16677 (KR); LEE, Chungik, Suwon-si Gyeonggi-do 16677 (KR); CHO, Jehyung, Suwon-si Gyeonggi-do 16677 (KR)
(74) Representative: Gulde & Partner
(86) International application number: PCT/KR2023/013063
(87) International publication number: WO 2024/053941

(57) **Abstract**

This electronic device may comprise: a housing that includes a front surface, a rear surface opposite the front surface, and side surfaces surrounding an inner space between the front surface and the rear surface; a display visible from the outside via the front surface; a printed circuit board that is disposed in the inner space and includes a first substrate surface and a second substrate surface opposite the first substrate surface, wherein a shield region in which one or more electrical elements are arranged is formed on the first substrate surface; and a shield can assembly that is connected to the printed circuit board and forms a partition wall disposed along the perimeter of the shield region and substantially perpendicular to the first substrate surface. The shield can assembly may include: one or more first shield members extending in a longitudinal direction; a plurality of second shield members that include a first portion having a longitudinal direction and a second portion having a longitudinal direction substantially perpendicular to the first portion; and a shield cover connected to the first shield members and the second shield members so as to cover the shield region.

## Description

### BACKGROUND

### 1. Field

The disclosure relates to an electronic device including a shield can.

### 2. Description of Related Art

Recently, the demand for portable electronic devices and the miniaturization and weight reduction of portable devices has been rapidly increasing. As the size of an electronic device decreases, the influence of noise reaching components disposed inside the electronic device may need to be reduced. For example, a shield can may be used to cover an electrical component mounted on a printed circuit board.

### SUMMARY

According to an aspect of the disclosure, an electronic device includes: a housing including a front surface, a rear surface opposite to the front surface, and a side surface enclosing an internal space between the front surface and the rear surface; a display visually exposed to an outside through the front surface; a printed circuit board (PCB) disposed in the internal space and including a first board surface and a second board surface that is opposite to the first board surface, and comprise a shield area in which at least one electrical component on the shield area of the board surface; and a shield can assembly disposed along a circumference of the shield area and connected to the PCB, the shield can assembly forming a partition wall substantially perpendicular to the board surface, wherein the shield can assembly comprises, while viewing the first board surface, at least one first shield member extending in a longitudinal direction, a plurality of second shield members comprising a first portion in a longitudinal direction and a second portion in a longitudinal direction that is substantially perpendicular to the first portion; and a shield cover connected to the first shield member and the plurality of second shield members to covering the shield area, and the at least one first shield member and the plurality of second shield members are disposed to enclose at least a portion of the shield area.

According to an aspect of the disclosure, a shield can assembly connected to a printed circuit board (PCB), while viewing a surface of the PCB, includes: at least one first shield member having a substantially straight shape; and a plurality of second shield members including a first portion extending in a longitudinal direction and a second portion extending from an end of the first portion in a longitudinal direction that is substantially perpendicular to the first portion, and the at least one first shield member and the plurality of second shield members are disposed to enclose a shield area of the PCB in a closed-loop shape.

According to an aspect of the disclosure, an electronic device includes: a housing including a front surface, a rear surface opposite to the front surface, and a side surface enclosing an internal space between the front surface and the rear surface; a display disposed on the front surface; a printed circuit board (PCB) disposed in the internal space and comprising at least one electrical component disposed on a surface thereof; and a shield can assembly connected to the PCB , the shield can assembly forming a shield area on the PCB and enclosing the electrical component, wherein the shield can assembly includes, while viewing a surface of the PCB, a first shield member and a second shield member disposed along the shield area to form a closed-loop and forming a partition wall perpendicular to the surface of the PCB; and a shield cover connected to the first shield member and the second shield member and covering surface part pf the PCB positioned in the shield area while viewing the surface of the PCB, the first shield member includes a first side surface part forming at least a portion of the partition wall and having substantially straight shape while viewing the surface of the PCB, and the second shield member includes a first portion and a second portion having longitudinal directions and that are perpendicular to each other while viewing the surface of the PCB and an upper flange that is formed on ends of the first portion and the second portion opposite to the surface of the PCB and configured to connect to the shield cover.

### BRIEF DESCRIPTION OF THE DRAWINGS

The above and other aspects, features, and advantages of certain embodiments of the present disclosure will be more apparent from the following detailed description, taken in conjunction with the accompanying drawings, in which:
FIG. 1 is a block diagram of an electronic device in a network environment according to an embodiment;
FIG. 2A is a front perspective view of an electronic device according to an embodiment;
FIG. 2B is a rear perspective view of the electronic device according to an embodiment;
FIG. 2C is an exploded perspective view of an electronic device according to an embodiment;
FIG. 3A is a perspective view of a printed circuit board (PCB) to which a shield can assembly is connected according to an embodiment;
FIG. 3B is an exploded perspective view of a PCB to which a shield can assembly is connected according to an embodiment;
FIG. 3C is a partially enlarged view of the IIIc area of the shield can assembly of FIG. 3B according to an embodiment;
FIG. 3D is a partially enlarged view of a PCB to which a shield can assembly is connected according to an embodiment;
FIGS. 4A and 4B are perspective views of a first shield member according to an embodiment;
FIG. 4C is a cross-sectional view of the first shield member of FIG. 4B taken along line IVc-IVc, according to an embodiment;
FIG. 5A is a perspective view of a second shield member according to an embodiment;
FIG. 5B is a cross-sectional view of the second shield member of FIG. 5A taken along line Vb-Vb, according to an embodiment;
FIG. 5C is a cross-sectional view of the second shield member of FIG. 5A taken along line Vc-Vc, according to an embodiment; and
FIG. 6A is a perspective view of a PCB to which a shield can assembly is connected according to an embodiment.
FIG. 6B is a perspective view of a PCB to which a shield can assembly is connected in a state in which a shield cover is removed from FIG. 6A, according to an embodiment.

### DETAILED DESCRIPTION

Hereinafter, embodiments will be described in detail with reference to the accompanying drawings. When describing the embodiments with reference to the accompanying drawings, like reference numerals refer to like elements and a repeated description related thereto will be omitted.

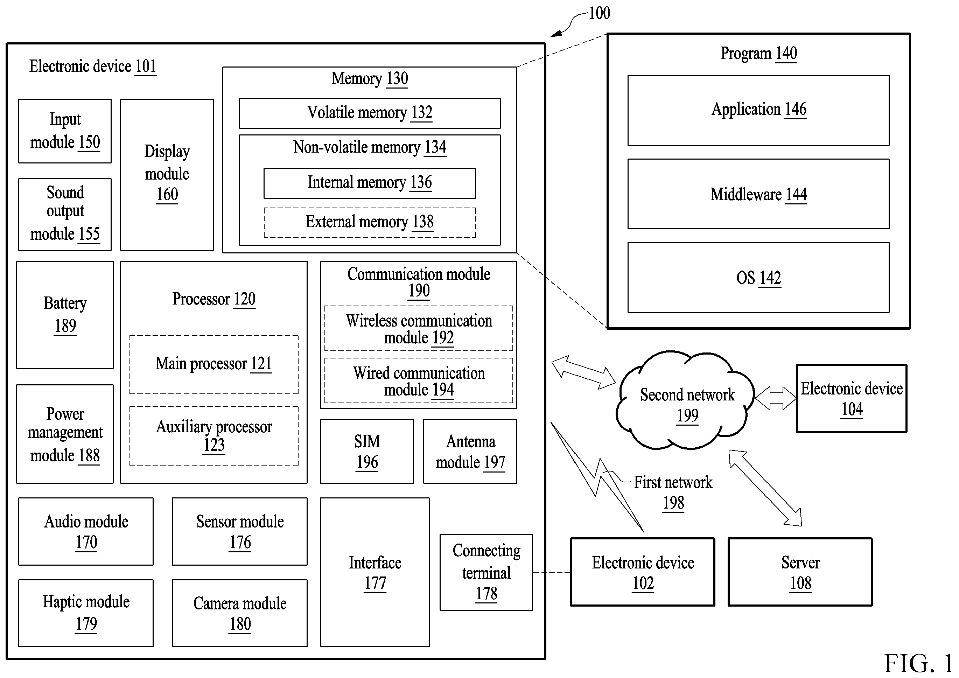

FIG. 1 is a block diagram of an electronic device in a network environment according to an embodiment.

Referring to FIG. 1, the electronic device 101 in the network environment 100 may communicate with an electronic device 102 via a first network 198 (e.g., a short-range wireless communication network), or communicate with at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, a memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one (e.g., the connecting terminal 178) of the above components may be omitted from the electronic device 101, or one or more other components may be added in the electronic device 101. In some embodiments, some (e.g., the sensor module 176, the camera module 180, or the antenna module 197) of the components may be integrated as a single component (e.g., the display module 160).

The processor 120 may execute, for example, software (e.g., a program 140) to control at least one other component (e.g., a hardware or software component) of the electronic device 101 connected to the processor 120, and may perform various data processing or computation. According to an embodiment, as at least a portion of data processing or computations, the processor 120 may store a command or data received from another component (e.g., the sensor module 176 or the communication module 190) in a volatile memory 132, process the command or the data stored in the volatile memory 132, and store resulting data in a non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with the main processor 121. For example, when the electronic device 101 includes the main processor 121 and the auxiliary processor 123, the auxiliary processor 123 may be adapted to consume less power than the main processor 121 or to be specific to a specified function. The auxiliary processor 123 may be implemented separately from the main processor 121 or as a part of the main processor 121.

The auxiliary processor 123 may control at least some of functions or states related to at least one (e.g., the display module 160, the sensor module 176, or the communication module 190) of the components of the electronic device 101, instead of the main processor 121 while the main processor 121 is in an inactive (e.g., sleep) state or along with the main processor 121 while the main processor 121 is in an active state (e.g., executing an application). According to an embodiment, the auxiliary processor 123 (e.g., an ISP or a CP) may be implemented as a portion of another component (e.g., the camera module 180 or the communication module 190) that is functionally related to the auxiliary processor 123. According to an embodiment, the auxiliary processor 123 (e.g., an NPU) may include a hardware structure specified for artificial intelligence (AI) model processing. An Al model may be generated by machine learning. Such learning may be performed by, for example, the electronic device 101 in which artificial intelligence is performed, or performed via a separate server (e.g., the server 108). Learning algorithms may include, but are not limited to, for example, supervised learning, unsupervised learning, semi-supervised learning, or reinforcement learning. The Al model may include a plurality of artificial neural network layers. An artificial neural network may include, for example, a deep neural network (DNN), a convolutional neural network (CNN), a recurrent neural network (RNN), a restricted Boltzmann machine (RBM), a deep belief network (DBN), a bidirectional recurrent deep neural network (BRDNN), a deep Q-network, or a combination of two or more thereof, but is not limited thereto. The Al model may additionally or alternatively include a software structure other than the hardware structure.

The memory 130 may store various data used by at least one component (e.g., the processor 120 or the sensor module 176) of the electronic device 101. The various pieces of data may include, for example, software (e.g., the program 140) and input data or output data for a command related thereto. The memory 130 may include the volatile memory 132 or the non-volatile memory 134.

The program 140 may be stored as software in the memory 130 and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output a sound signal to the outside of the electronic device 101. The sound output module 155 may include, for example, a speaker or a receiver. The speaker may be used for general purposes, such as playing multimedia or playing record. The receiver may be used to receive an incoming call. According to an embodiment, the receiver may be implemented separately from the speaker or as a portion of the speaker.

The display module 160 may visually provide information to the outside (e.g., a user) of the electronic device 101. The display module 160 may include, for example, a control circuit for controlling a display, a hologram device, or a projector and control circuitry to control a corresponding one of the display, the hologram device, and the projector. According to an embodiment, the display module 160 may include a touch sensor adapted to sense a touch, or a pressure sensor adapted to measure an intensity of a force incurred by the touch.

The audio module 170 may convert a sound into an electric signal or vice versa. According to an embodiment, the audio module 170 may obtain the sound via the input module 150 or output the sound via the sound output module 155 or an external electronic device (e.g., an electronic device 102 such as a speaker or a headphone) directly or wirelessly connected to the electronic device 101.

The sensor module 176 may detect an operational state (e.g., power or temperature) of the electronic device 101 or an environmental state (e.g., a state of a user) external to the electronic device 101, and generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., by wire) or wirelessly. According to an embodiment, the interface 177 may include, for example, a high-definition multimedia interface (HDMI), a universal serial bus (USB) interface, a secure digital (SD) card interface, or an audio interface.

The connecting terminal 178 may include a connector via which the electronic device 101 may be physically connected to an external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or an electrical stimulus which may be recognized by a user via his or her tactile sensation or kinesthetic sensation. According to an embodiment, the haptic module 179 may include, for example, a motor, a piezoelectric element, or an electric stimulator.

The camera module 180 may capture a still image and moving images. According to an embodiment, the camera module 180 may include one or more lenses, image sensors, ISPs, or flashes.

The power management module 188 may manage power supplied to the electronic device 101. According to an embodiment, the power management module 188 may be implemented as, for example, at least a part of a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently of the processor 120 (e.g., an AP) and that support a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module, or a power line communication (PLC) module). A corresponding one of these communication modules may communicate with the external electronic device 104 via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., a LAN or a wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., a mmWave band) to achieve, e.g., a high data transmission rate. The wireless communication module 192 may support various technologies for securing performance on a high-frequency band, such as, e.g., beamforming, massive multiple-input and multiple-output (MIMO), full dimensional MIMO (FD-MIMO), an array antenna, analog beam-forming, or a large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in a communication network, such as the first network 198 or the second network 199, may be selected by, for example, the communication module 190 from the plurality of antennas. The signal or the power may be transmitted or received between the communication module 190 and the external electronic device via the at least one selected antenna. According to an embodiment, another component (e.g., a radio frequency integrated circuit (RFIC)) other than the radiating element may be additionally formed as a part of the antenna module 197.

According to an embodiment, the antenna module 197 may form a mmWave antenna module. According to an embodiment, the mmWave antenna module may include a PCB, an RFIC disposed on a first surface (e.g., a bottom surface) of the PCB or adjacent to the first surface and capable of supporting a designated a high-frequency band (e.g., the mmWave band), and a plurality of antennas (e.g., array antennas) disposed on a second surface (e.g., a top or a side surface) of the PCB, or adjacent to the second surface and capable of transmitting or receiving signals in the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the external electronic devices 102 or 104 may be a device of the same type as or a different type from the electronic device 101. According to an embodiment, all or some of operations to be executed by the electronic device 101 may be executed at one or more of external electronic devices (e.g., the external electronic devices 102 and 104, or the server 108). For example, if the electronic device 101 needs to perform a function or a service automatically, or in response to a request from a user or another device, the electronic device 101, instead of, or in addition to, executing the function or the service, may request one or more external electronic devices to perform at least part of the function or the service. The one or more external electronic devices receiving the request may perform the at least part of the function or the service requested, or an additional function or an additional service related to the request, and may transfer an outcome of the performing to the electronic device 101. The electronic device 101 may provide the result, with or without further processing the result, as at least part of a response to the request. To this end, cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., a smart home, a smart city, a smart car, or healthcare) based on 5G communication technology or loT-related technology.

The electronic device according to the embodiments disclosed herein may be one of various types of electronic devices. The electronic device may include, for example, a portable communication device (e.g., a smartphone), a computer device, a portable multimedia device, a portable medical device, a camera, a wearable device, or a home appliance device. According to an embodiment of the disclosure, the electronic devices are not limited to those described above.

It should be appreciated that embodiments of the disclosure and the terms used therein are not intended to limit the technological features set forth herein to particular embodiments and include various changes, equivalents, or replacements for a corresponding embodiment. In connection with the description of the drawings, like reference numerals may be used for similar or related components. It is to be understood that a singular form of a noun corresponding to an item may include one or more of the things, unless the relevant context clearly indicates otherwise. As used herein, "A or B", "at least one of A and B", "at least one of A or B", "A, B or C", "at least one of A, B and C", and "A, B, or C," each of which may include any one of the items listed together in the corresponding one of the phrases, or all possible combinations thereof. Terms such as "first", "second", or "first" or "second" may simply be used to distinguish the component from other components in question, and may refer to components in other aspects (e.g., importance or order) is not limited. It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., by wire), wirelessly, or via a third element.

As used in connection with embodiments of the disclosure, the term "module" may include a unit implemented in hardware, software, or firmware, and may interchangeably be used with other terms, for example, "logic", "logic block", "part", or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., an internal memory 136 or an external memory 138) that is readable by a machine (e.g., the foldable electronic device 101). For example, a processor (e.g., the processor 120) of the machine (e.g., the foldable electronic device 101) may invoke at least one of the one or more instructions stored in the storage medium and execute it. This allows the machine to be operated to perform at least one function according to the at least one instruction invoked. The one or more instructions may include code generated by a compiler or code executable by an interpreter. The machine-readable storage medium may be provided in the form of a non-transitory storage medium. Here, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read-only memory (CD-ROM)), or be distributed (e.g., downloaded or uploaded) online via an application store (e.g., PlayStore^{™}), or between two user devices (e.g., smartphones) directly. If distributed online, at least part of the computer program product may be temporarily generated or at least temporarily stored in the machine-readable storage medium, such as memory of the manufacturer's server, a server of the application store, or a relay server.

According to an embodiment, each component (e.g., a module or a program) of the above-described components may include a single entity or multiple entities, and some of the multiple entities may be separately disposed in different components. According to an embodiment, one or more of the above-described components may be omitted, or one or more other components may be added. Alternatively or additionally, a plurality of components (e.g., modules or programs) may be integrated into a single component. In such a case, according to embodiments, the integrated component may still perform one or more functions of each of the plurality of components in the same or similar manner as they are performed by a corresponding one of the plurality of components before the integration. According to embodiments, operations performed by the module, the program, or another component may be carried out sequentially, in parallel, repeatedly, or heuristically, or one or more of the operations may be executed in a different order or omitted, or one or more other operations may be added.

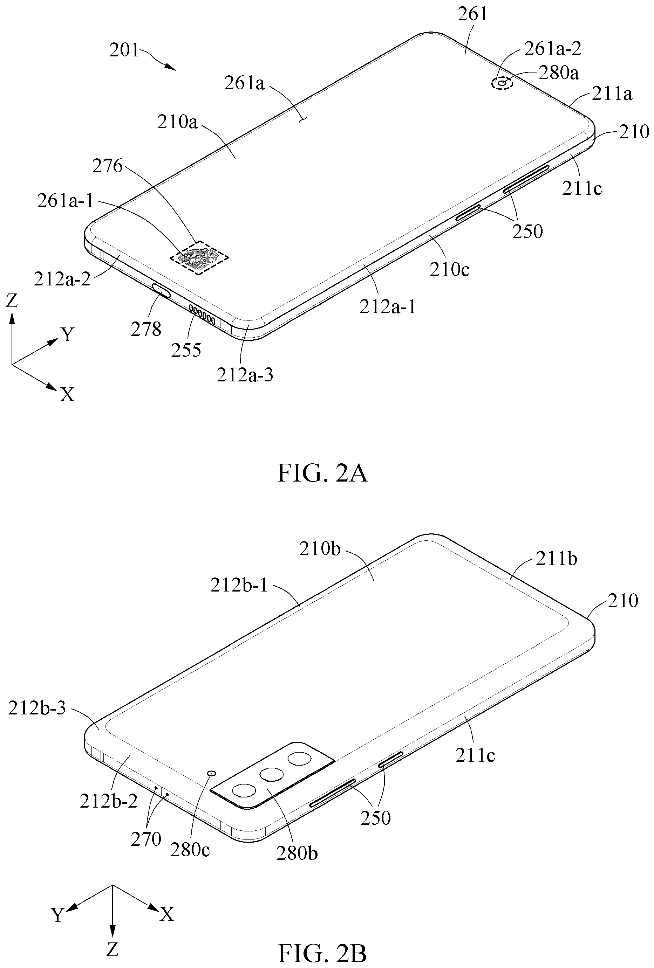

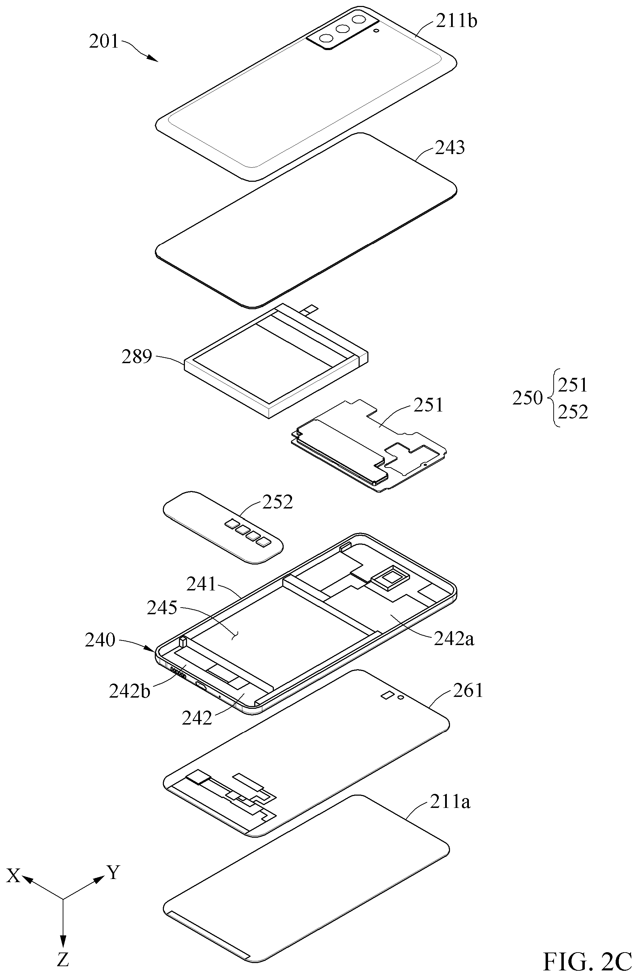

FIG. 2A is a front perspective view of an electronic device according to an embodiment. FIG. 2B is a rear perspective view of the electronic device according to an embodiment. FIG. 2C is an exploded perspective view of an electronic device according to an embodiment.

Referring to FIGS. 2A to 2C, an electronic device 201 (e.g., the electronic device 101 of FIG. 1) may include a housing 210 including a first surface 210a (e.g., a front surface), a second surface 210b (e.g., a rear surface), and a third surface 210c (e.g., a side surface) enclosing a space between the first surface 210a and the second surface 210b.

In an embodiment, the first surface 210a may be formed by a first plate 211a of which at least a portion is substantially transparent. For example, the first plate 211a may include a polymer plate or a glass plate including at least one coating layer. In an embodiment, the second surface 210b may be formed of a second plate 211b that is substantially opaque. For example, the second plate 211b may be formed of coated or tinted glass, ceramic, polymer, metal (e.g., aluminum, stainless steel (STS), or magnesium), or a combination thereof. In an embodiment, the third surface 210c may be formed by a frame 211c that is coupled to the first plate 211a and the second plate 211b and includes a metal and/or a polymer. In an embodiment, the second plate 211b and the frame 211c may be integrated and seamlessly formed. In an embodiment, the second plate 211b and the frame 211c may be formed of substantially the same material (e.g., aluminum).

In an embodiment, the first plate 211a may include a plurality of first edge areas 212a-1. The plurality of first edge areas 212a-1 may face the second plate 211b from at least a partial area of the first surface 210a. A plurality of first edge regions 212a-1 may be in contact with the frame 211c. The plurality of first edge areas 212a-1 may extend in one direction (e.g., the +/-Y direction). The first plate 211a may include a plurality of second edge areas 212a-2. The plurality of second edge areas 212a-2 may face the second plate 211b from at least a partial area of the first surface 210a. A plurality of second edge areas 212a-2 may be in contact with the frame 211c. The plurality of second periphery areas 212a-2 may extend in a direction (e.g., the +/-X direction) different from an extending direction (e.g., the +/-Y direction) of the plurality of first periphery areas 212a-1. The first plate 211a may include a plurality of third edge areas 212a-3. The plurality of third edge areas 212a-3 may face the second plate 211b from at least a partial area of the first surface 210a. A plurality of third edge regions 212a-3 may be in contact with the frame 211c. The plurality of third edge areas 212a-3 may be between the plurality of first edge areas 212a-1 and the plurality of second edge areas 212a-2.

In an embodiment, the second plate 211b may include a plurality of fourth edge areas 212b-1. The plurality of fourth edge areas 212b-1 may face the first plate 211a from at least a partial area of the second surface 210b. A plurality of fourth edge areas 212b-1 may be in contact with the frame 211c. The plurality of fourth edge areas 212b-1 may extend in one direction (e.g., +/-Y direction). The second plate 211b may include a plurality of fifth edge areas 212b-2. The plurality of fifth edge areas 212b-2 may face the first plate 211a from at least a partial area of the second surface 210b. A plurality of fifth edge areas 212b-2 may be in contact with the frame 211c. The plurality of second edge areas 212a-2 may extend in a direction (e.g., the +/-X direction) different from an extending direction (e.g., the +/-Y direction) of the plurality of first edge areas 212a-1. The second plate 211b may include a plurality of sixth edge areas 212b-3. The plurality of sixth edge areas 212b-3 may face the first plate 211a from at least a partial area of the second surface 210b. A plurality of sixth edge areas 212b-3 may be in contact with the frame 211c. The plurality of sixth edge areas 212b-3 may be between the plurality of fourth edge areas 212b-1 and the plurality of fifth edge areas 212b-2.

In an embodiment, the electronic device 201 may include a display 261 (e.g., the display module 160 of FIG. 1). In an embodiment, the display 261 may be positioned on the first surface 210a. In an embodiment, the display 261 may be visible through at least a portion of the first plate 211a (e.g., the plurality of first edge areas 212a-1, the plurality of second edge areas 212a-2, and/or the plurality of third edge areas 212a-3). In an embodiment, the display 261 may have a shape that is substantially the same as the shape of an outer edge of the first plate 211a. In an embodiment, the edge of the display 261 may substantially coincide with the outer edge of the first plate 211a.

In an embodiment, the display 261 may include a touch sensing circuit, a pressure sensor for measuring an intensity (pressure) of a touch, and/or a digitizer for detecting a magnetic-type stylus pen.

In an embodiment, the display 261 may include a screen display area 261a that is visually exposed to display content using pixels. In an embodiment, the screen display area 261a may include a sensing area 261a-1. The sensing area 261a-1 may overlap at least one area of the screen display area 261a. The sensing area 261a-1 may allow transmission of an input signal related to a sensor module 276 (e.g., the sensor module 176 of FIG. 1). The sensing area 261a-1 may display content, similarly to the screen display area 261a that does not overlap the sensing area 261a-1. For example, the sensing area 261a-1 may display the content while the sensor module 276 is not operating. At least a portion of a camera area 261a-2 may overlap the screen display area 261a. In an embodiment, the screen display area 261a may include the camera area 261a-2. The camera area 261a-2 may allow transmission of an optical signal related to a first camera module 280a (e.g., the camera module 180 of FIG. 1). At least a portion of the camera area 261a-2, which overlaps the screen display area 261a, may display content, similarly to the screen display area 261a that does not overlap the camera area 261a-2. For example, the camera area 261a-2 may display the content while the first camera module 280a is not operating.

In an embodiment, the electronic device 201 may include an audio module 270 (e.g., the audio module 170 of FIG. 1). In an embodiment, the audio module 270 may be positioned on the third surface 210c. In an embodiment, the audio module 270 may obtain sound through at least one hole.

In an embodiment, the electronic device 201 may include the sensor module 276. In an embodiment, the sensor module 276 may be positioned on the first surface 210a. The sensor module 276 may form the sensing area 261a-1 in at least a portion of the screen display area 261a. The sensor module 276 may receive an input signal transmitted through the sensing area 261a-1 and generate an electrical signal based on the received input signal. For example, the input signal may have a designated physical quantity (e.g., heat, light, temperature, sound, pressure, or ultrasound). As another example, the input signal may include a signal related to biometric information (e.g., a fingerprint) of a user.

In an embodiment, the electronic device 201 may include a first camera module 280a (e.g., the camera module 180 of FIG. 1). In an embodiment, the first camera module 280a may be positioned on the first side 210a. In an embodiment, at least a portion of the first camera module 280a may be positioned under the display 261. In an embodiment, the first camera module 280a may receive an optical signal transmitted through the camera area 261a-2.

In an embodiment, the electronic device 201 may include a second camera module 280b (e.g., the camera module 180 of FIG. 1). The second camera module 280b may be positioned on the second surface 210b. In an embodiment, the second camera module 280b may include a plurality of camera modules (e.g., a dual camera, a triple camera, or a quad camera).

In an embodiment, the electronic device 201 may include a flash 280c. The flash 280c may be positioned on the second surface 210b. In an embodiment, the flash 280c may include a light-emitting diode or a xenon lamp.

In an embodiment, the electronic device 201 may include a sound output module 255 (e.g., the sound output module 155 of FIG. 1). In an embodiment, the sound output module 255 may be positioned on the third surface 210c. In one embodiment, the sound output module 255 may include one or more holes.

The electronic device 201 may include an input module 250 (e.g., the input module 150 of FIG. 1). In an embodiment, the input module 250 may be positioned on the third surface 210c. In an embodiment, the input module 250 may include at least one key input device.

In an embodiment, the electronic device 201 may include a connecting terminal 278 (e.g., the connecting terminal 178 of FIG. 1). In an embodiment, the connecting terminal 278 may be positioned on the third surface 210c. For example, when the electronic device 201 is viewed in a direction (e.g., the +Y direction), the connecting terminal 278 may be positioned on the substantially central portion of the third surface 210c and the sound output module 255 may be positioned on one side (e.g., a right side) with respect to the connecting terminal 278.

In an embodiment, the electronic device 201 may include a support body 240, one or more PCBs 251 and 252, and a battery 289 (e.g., the battery 189 of FIG. 1). At least a portion of the support body 240 may form the housing 210 together with the first plate 211a and the second plate 211b. In an embodiment, the PCBs 251 and 252 may include the first PCB 251 and the second PCB 252. The first PCB 251 and the second PCB 252 may be spaced apart from each other in the electronic device 201 and may be electrically connected to each other.

In an embodiment, the support body 240 may include a first frame structure 241, a second frame structure 243, and a plate structure 242. The first frame structure 241 may enclose an edge of the plate structure 242. The first frame structure 241 may connect an edge of the first plate 211a to an edge of the second plate 211b. The first frame structure 241 may enclose a space between the first plate 211a and the second plate 211b. At least a portion of the first frame structure 241 may form the third surface 210c of the electronic device 201. The second frame structure 243 may be positioned between the first frame structure 241 and the second plate 211b. The first frame structure 241 and the second frame structure 243 may form at least a portion of the frame 211c. The plate structure 242 may include a first portion 242a for accommodating the first PCB 251 and a second portion 242b for accommodating the second PCB 252. The display 261 may be positioned on one side (e.g., the lower surface or +Z-axis direction) of the plate structure 242. The first PCB 251 and the second PCB 252 may be positioned on the other surface (e.g., the upper surface or -Z axis direction) of the plate structure 242. In an embodiment, the plate structure 242 may include an opening 245. The opening 245 may be positioned between the first portion 242a and the second portion 242b. The opening 245 may pass through both sides of the plate structure 242. The opening 245 may accommodate the battery 289.

Meanwhile, the embodiments provided herein may also apply to electronic devices of various shapes/forms (e.g., a foldable electronic device, a slidable electronic device, a digital camera, a digital video camera, a tablet PC, a laptop computer, and other electronic devices), in addition to the electronic device shown in FIGS. 2A to 2C.

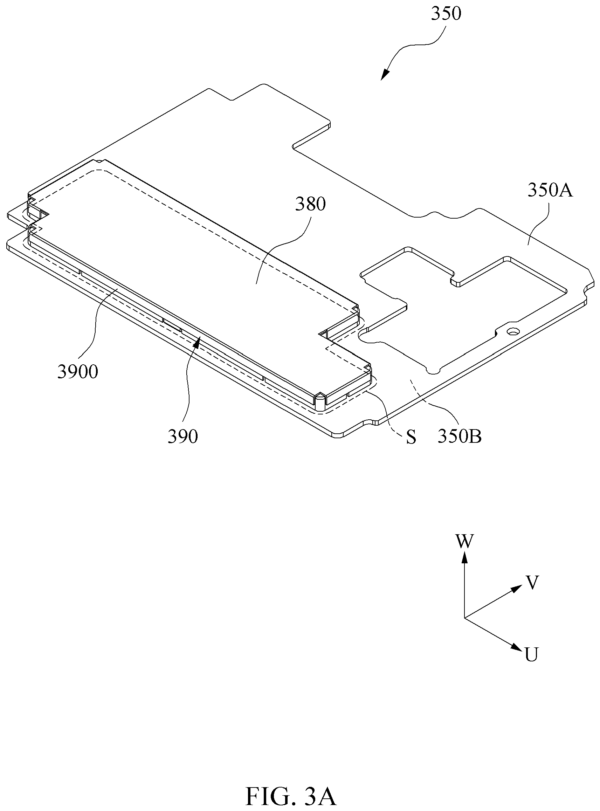

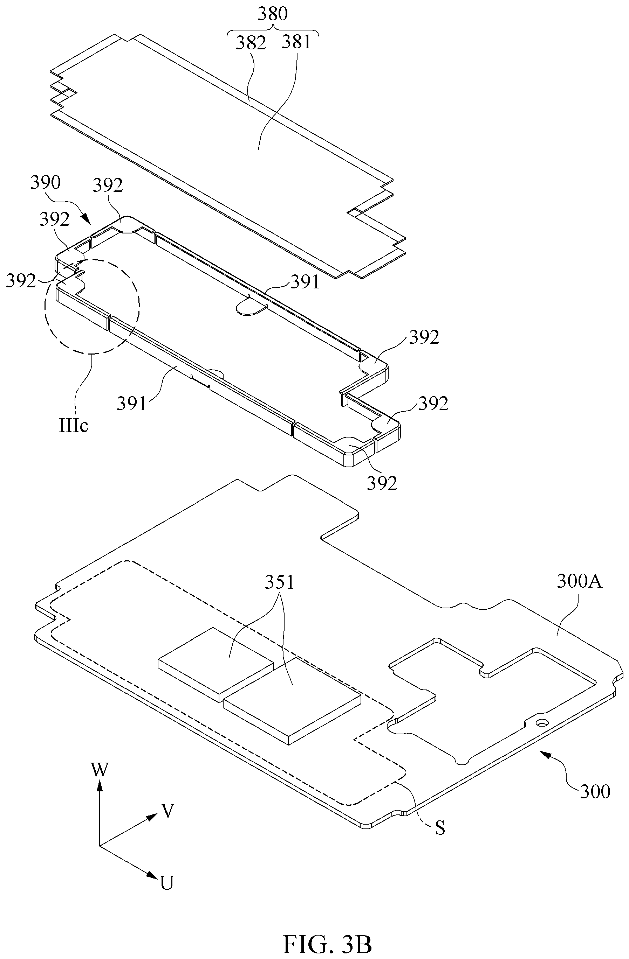

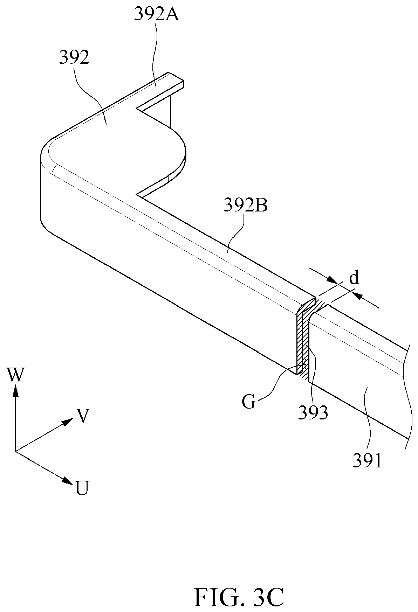

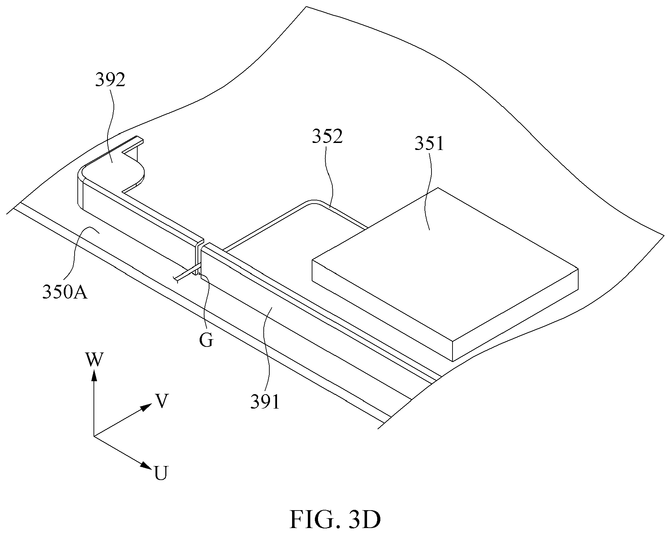

FIG. 3A is a perspective view of a printed circuit board (PCB) to which a shield can assembly is connected according to an embodiment. FIG. 3B is an exploded perspective view of a PCB to which a shield can assembly is connected according to an embodiment. FIG. 3C is a partially enlarged view of the IIIc area of the shield can assembly of FIG. 3B according to an embodiment. FIG. 3D is a partially enlarged view of a PCB to which a shield can assembly is connected according to an embodiment.

Referring to FIGS. 3A to 3D, in an embodiment, a shield can assembly 390 may be connected to a PCB 300.

In an embodiment, the PCB 300 may be disposed in an electronic device (e.g., the electronic device 201 of FIG. 2A). In an embodiment, the PCB 300 may be formed as a flat plate and may have various shapes and sizes. In an embodiment, the PCB 300 may include a first board surface 300A oriented in a first direction (e.g., the -W direction of FIG. 3A) and a second board surface 300B oriented in an opposite direction (e.g., the +W direction of FIG. 3A) to the first board surface 300A. In an embodiment, at least one electrical component 351, for example, the electrical component 351 such as an application processor (AP) may be disposed on a surface of the PCB 300, for example, the first board surface 300A or the second board surface 300B. In an embodiment, circuit wiring 352 may be formed on the surface of the PCB 300 to transmit an electrical signal.

In an embodiment, the shield can assembly 390 may be mounted on the PCB 300. For example, the shield can assembly may be soldered to the PCB 300 through an SMD (surface mounted device) process. In an embodiment, the shield can assembly 390 may cover at least one electrical component 351 disposed on the PCB 300. For example, the shield can assembly 390 may block electromagnetic waves generated by the covered electrical component 351. In an embodiment, the shield can assembly 390 may form a shield area S on the PCB 300. In an embodiment, the shield can assembly 390 may block the transmission of electromagnetic waves between the inside and outside of the shield area S by covering the at least one electrical component 351 positioned on the shield area S and may prevent or mitigate an occurrence of noise between electrical components disposed inside and outside of the shield area S.

Hereinafter, an embodiment is described based on the assumption that the shield can assembly 390 is disposed on the first board surface 300A of the PCB 300. However, it shall be noted that the embodiment is for ease of description. For example, unlike drawings, the electrical component 351 and the shield can assembly 390 may be disposed on the second board surface 300B of the PCB 300 and may also be simultaneously disposed on the first board surface 300A and the second board surface 300B. In addition, although the electrical component 351 is disposed only in the shield area S covered by the shield can assembly 390 in the first board surface 300A of the PCB 300 in the drawings, this is also for ease of description. In an embodiment, the electrical component 351 may be disposed on the second board surface 300B of the PCB 300 and may be disposed on an area of the PCB 300 that corresponds to the outside of the shield area S.

In an embodiment, the shield can assembly 390 may form a surface of the PCB 300, for example, the shield area S on the first board surface 300A. In an embodiment, the shield can assembly 390 may form a partition wall 3900 that is disposed along the circumference of the shield area S and is substantially perpendicular to the first board surface 300A. For example, the partition wall 3900 formed by the shield can assembly 390 may protrude (e.g., the +W direction of FIG. 3B) from the surface of the PCB 300. The partition wall 3900 formed by the shield can assembly 390 may be disposed in a substantially closed-loop shape along the edge of the shield area S while viewing the first board surface 300A. In an embodiment, at least a portion of a gap between the partition wall 3900 disposed along the edge of the shield area S may be open.

In an embodiment, the shield can assembly 390 may be formed by a combination of a plurality of unit shield members 391 and 392. For example, the plurality of unit shield members 391 and 392 may be mounted on the board surface 300A of the PCB 300 along the shield area S to form the shield can assembly 390. In an embodiment, the shield can assembly 390 may include a first shield member 391, a second shield member 392, and a shield cover 380 disposed on an upper end of the first shield member 391 and the second shield member 392. Hereinafter, for ease of description, a portion in contact with the first board surface 300A may be referred to as lower ends of the first shield member 391 and the second shield member 392 and a portion that is opposite to the first board surface 300A may be referred to as upper ends of the first shield member 391 and the second shield member 392.

In an embodiment, the first shield member 391 and the second shield member 392 may be disposed on the surface of the PCB 300, for example, the first board surface 300A of the PCB 300. In an embodiment, the first shield member 391 and the second shield member 392 may be continuously disposed along the circumference of the shield area S. In an embodiment, the first shield member 391 and the second shield member 392 may form portions of the partition wall 3900 along the circumference of the shield area S, respectively. For example, the first shield member 391 and the second shield member 392 may be disposed along the circumference of the shield area S to enclose the shield area S in the closed-loop shape. In an embodiment, the first shield member 391 and the second shield member 392 may have different shapes. In an embodiment, depending on the shape of the shield area S covered by the shield can assembly 390, the numbers and disposed positions of the first shield members 391 and the second shield members 392 disposed in the shield area S may vary. For example, the shield can assembly 390 may include one or more first shield members 391 and a plurality of second shield members 392.

In an embodiment, the first shield member 391 may be disposed on an edge part of the shield area S in a shape of a substantially straight line. In an embodiment, the first shield member 391 may have a substantially straight shape while viewing the first board surface 300A. For example, the first shield member 391 may extend in a longitudinal direction.

In an embodiment, the second shield member 392 may be disposed on an edge part of the shield area S forming a curved shape, for example, a vertex. In an embodiment, the second shield member 392 may have a shape in which at least a portion is partially curved while viewing the first board surface 300A. For example, the second shield member 392 may include a first portion 392A and a second portion 392B vertically connected to each other while viewing the first board surface 300A (e.g., viewing in the -W direction of FIG. 3B). In this case, the first portion 392A may extend in a longitudinal direction L2. The second portion 392B may extend in a longitudinal direction L3 that is substantially perpendicular to the first portion 392A and may be connected to an end of the first portion 392A. In an embodiment, while viewing the first board surface 300A, the first portion 392A and the second portion 392B of the second shield member 392 may have different lengths. However, this is an example and the first portion 392A and the second portion 392B may have substantially the same lengths.

In an embodiment, while being connected to the PCB 300, each of the first shield member 391 and the second shield member 392 may form a portion of the partition wall 3900 enclosing the circumference of the shield area S. In an embodiment, the partition wall 3900 formed by the first shield member 391 and the second shield member 392 may have a substantially constant thickness. In this case, while viewing the first board surface 300A, an inner boundary part of the shield area S formed by the first shield member 391 and the second shield member 392, for example, at least a portion of the shield area S enclosed by the first shield member 391 and the second shield member 392 may be open. In an embodiment, the shield cover 380 may be disposed on upper parts of the first shield member 391 and the second shield member 392 to cover an open part of the shield area S, for example, an internal space of the partition wall 3900 formed by the first shield member 391 and the second shield member 392. For example, the shield area S may be enclosed by the first board surface 300A of the PCB 300, the partition wall 3900 formed by the first shield member 391 and the second shield member 392, and the shield cover 380.

In an embodiment, the shield cover 380 may be formed as a shape that substantially corresponds to the shape of the shield area S. For example, the shield cover 380 may overlap the entire shield area S while viewing the first board surface 300A. In an embodiment, while being connected to the first shield member 391 and the second shield member 392, the shield cover 380 may include a first cover portion 381 that is disposed substantially parallel with the first board surface 300A and covers the upper part of the shield area S and a second cover portion 382 that is bendably connected to an edge of the first cover portion 381 and is connected to an outer circumferential surface of the partition wall 3900 formed by the first shield member 391 and the second shield member 392.

In an embodiment, the shield cover 380 may have a multi-layer structure. For example, the shield cover 380 may include a first film including a plastic material, for example, a polyethylene terephthalate (PET) material, and an adhesive second film stacked on the first film. In an embodiment, the second film may include, for example, a nickel-plated copper material. In an embodiment, the shield cover 380 may be formed of a shielding material, for example, a metal material such as steel use stainless, but the example is not limited thereto.

In an embodiment, a gap G may be formed between the partition wall 3900 formed by the first shield member 391 and the second shield member 392 as shown in FIG. 3C. For example, while viewing the first board surface 300A, the gap G may be formed between the first shield member 391 and the second shield member 392 that are adjacent to each other, between a pair of adjacent first shield members 391, or between a pair of adjacent second shield members 392. In an embodiment, when viewing in a direction parallel with the first board surface 300A, the width of the gap G between the shield members may be approximately less than 0.1 mm.

In an embodiment, a bonding member 393 may be disposed on the gap G between the partition wall 3900 formed by the first shield member 391 and the second shield member 392. In an embodiment, the bonding member 393 may seal the gap G between the partition wall 3900 by coating the outer surface of the shield can assembly 390, for example, the partition wall 3900 formed by the first shield member 391 and the second shield member 392.

In an embodiment, the gap G between the partition wall 3900 formed by the first shield member 391 and the second shield member 392 may function as an arrangement path of the circuit wiring 352 to transmit an electrical signal between the inside of the shield area S and the outside of the shield area S. For example, as shown in FIG. 3D, the PCB 300 may include the circuit wiring 352 formed on the first board surface 300A and extending from the inside of the shield area S to the outside of the shield area S through the gap G between the first shield member 391 and the second shield member 392. In an embodiment, the circuit wiring 352 extending through the gap G may electrically connect the electrical component 351 disposed inside the shield area S to the element component 351 disposed outside of the shield area S.

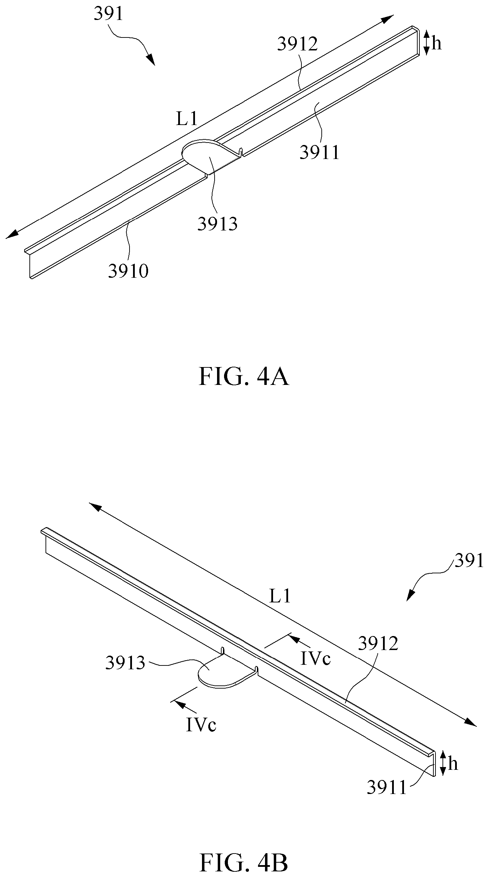

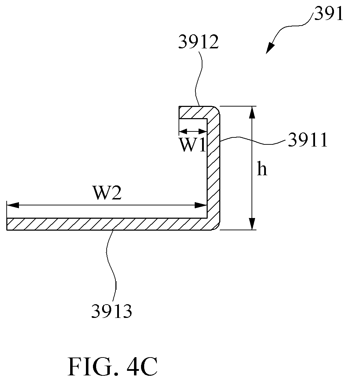

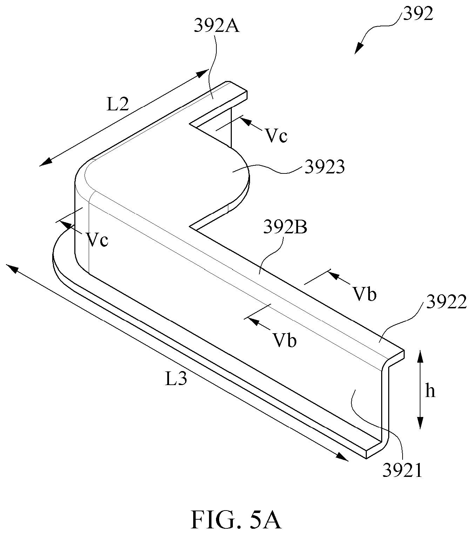

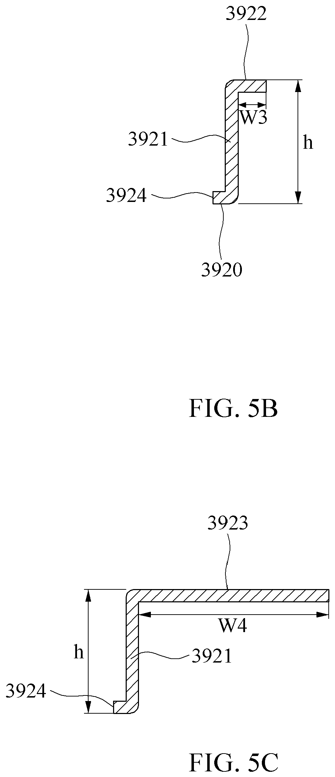

FIGS. 4A and 4B are perspective views of a first shield member according to an embodiment and FIG. 4C is a cross-sectional view of the first shield member of FIG. 4B taken along line IVc-IVc, according to an embodiment. FIG. 5A is a perspective view of a second shield member according to an embodiment, FIG. 5B is a cross-sectional view of the second shield member of FIG. 5A taken along line Vb-Vb, according to an embodiment, and FIG. 5C is a cross-sectional view of the second shield member of FIG. 5A taken along line Vc-Vc, according to an embodiment.

Referring to FIGS. 4A and 4C, a structure of the first shield member 391 is described. In an embodiment, the first shield member 391 may extend in a longitudinal direction L1 to form a substantially straight shape. In an embodiment, the second shield member 392 may include a first side surface part 3911, a first support part 3912, and a lower flange 3913.

In an embodiment, the first side surface part 3911 may extend in a height direction h toward the upper end of the first shield member 391 from a lower end of the first shield member 391, for example, a part connected to the first board surface. In an embodiment, while the first shield member 391 is connected to the first board surface (e.g., the first board surface 300A of FIG. 3A), the first side surface part 3911 may extend in the height direction h that is substantially perpendicular to the first board surface. In an embodiment, the first side surface part 3911 may form at least a portion of a partition wall (e.g., the partition wall 3900 of FIG. 3B) formed by the shield can assembly. In an embodiment, the thickness of the first side surface part 3911 in the height direction h may be substantially constant.

In an embodiment, the first support part 3912 may extend in a direction that is substantially perpendicular to the height direction h from the upper end of the first side surface part 3911, for example, the end of the first side surface part 3911 that is opposite to the first board surface. For example, while the first shield member 391 is connected to the first board surface, the first support part 3912 may extend from the first side surface part 3911 in a direction that is substantially parallel with the first board surface. In an embodiment, the first support part 3912 may perform the function of supporting a shield cover (e.g., the shield cover 380 of FIG. 3A).

In an embodiment, the lower flange 3913 may be formed on a portion of the first side surface part 3911. In an embodiment, the lower flange 3913 may protrude in a direction parallel with the first board surface from the lower end of the first side surface part 3911, for example, the end of the first side surface part 3911 connected to the first board surface. In other words, the lower flange 3913 may extend in a direction that is substantially parallel with the height direction h of the first side surface part 3911. In an embodiment, in a process of connecting the first shield member 391 to the first board surface (e.g., the first board surface 300A of FIG. 3B), the lower flange 3913 may perform the function of supporting the first shield member 391 while simultaneously performing a function as a pick-up point for arranging the first shield member 391. For example, the lower flange 3913 may function as a part picked by a mounter when mounting the first shield member 391 on the first board surface.

In an embodiment, the first support part 3912 and the lower flange 3913 may extend in the same direction from the first side surface part 3911 as shown in FIG. 4C. As shown in FIG. 3B, while the first shield member 391 is connected to the first board surface, the first support part 3912 and the lower flange 3913 may extend toward the inside of the shield area. In this case, a first width W1 in which the first support part 3912 extends from the first side surface part 3911 may be less than a second width W2 in which the lower flange 3913 extends from the first side surface part 3911. In an embodiment, a first bonding pad (not shown) for mounting the first shield member 391 may be disposed on a surface of a PCB (e.g., the PCB 300 of FIG. 3B). For example, the first bonding pad having a shape that substantially corresponds to the surface shape of the first shield member 391 facing a first board surface (e.g., the first board surface 300A of FIG. 3B) may be disposed on the first board surface 300A. For example, while viewing the first board surface, the first bonding pad may have a shape that substantially corresponds to or overlaps a lower part 3910 of the first side surface part 3911 or a lower surface of the lower flange 3913. In this case, the first shield member 391 may be soldered to the first bonding pad attached to the first board surface through an SMD process. However, the mounting method of the first shield member 391 on the PCB is not limited thereto.

Referring to FIGS. 5A to 5C, a structure of the second shield member 392 is described. For reference, FIG. 5A is a perspective view of a second shield member according to an embodiment, FIG. 5B is a cross-sectional view of the second shield member of FIG. 5A taken along line Vb-Vb, according to an embodiment, and FIG. 5C is a cross-sectional view of the second shield member of FIG. 5A taken along line Vc-Vc, according to an embodiment.

In an embodiment, while viewing from the top as shown in FIG. 5A, the second shield member 392 may include a first portion 392A and a second portion 392B that are extending in directions perpendicular to each other. In an embodiment, the second shield member 392 may include a second side surface part 3921, a second support part 3922, a lower support part 3924, and an upper flange 3923.

In an embodiment, the second side surface part 3921 may extend in the height direction h perpendicular to the first board surface (e.g., the first board surface 300A of FIG. 3A). In an embodiment, the second side surface part 3921 may form at least a portion of a partition wall (e.g., the partition wall 3900 of FIG. 3B) formed by the shield can assembly. In an embodiment, the thickness of the second side surface part 3921 in the height direction h may be less than or equal to 0.15 mm.

In an embodiment, the second support part 3922 may extend in a direction that is substantially perpendicular to the height direction h from the upper end of the second side surface part 3921, for example, the end of the second side surface part 3921 that is opposite to the first board surface. For example, while the second shield member is connected to the first board surface as shown in FIG. 3B, the second support part 3922 may extend from the second side surface part 3921 in a direction that is substantially parallel with the first board surface. In an embodiment, the second support part 3922 may perform the function of supporting a shield cover (e.g., the shield cover 380 of FIG. 3A).

In an embodiment, the lower support part 3924 may extend in a direction that is substantially perpendicular to the height direction h from the lower end of the second side surface part 3921, for example, the end of the second side surface part 3921 connected to the first board surface. In an embodiment, the second support part 3922 may perform the function of supporting the second shield member in a process of connecting the second shield member to the first board surface. The lower support part 3924 may have a wider width than the second side surface part 3921 based on a cross-section as shown in FIG. 5C. Accordingly, the second shield member 392 may be stably supported by the lower support part 3924 with respect to the PCB.

In an embodiment, a second bonding pad (not shown) for mounting the second shield member 392 may be disposed on a surface of a PCB (e.g., the PCB 300 of FIG. 3B). For example, the second bonding pad (not shown) having a shape that substantially corresponds to the lower surface shape of the second shield member 392 facing a first board surface (e.g., the first board surface 300A of FIG. 3B) may be disposed on the first board surface 300A. For example, while viewing the first board surface, the second bonding pad may have a shape that substantially corresponds to or overlaps a lower surface 3920 of the second shield member 392 including the lower flange 3913. In this case, the second shield member 392 may be soldered to the second bonding pad attached to the first board surface through an SMD process. However, the mounting method of the second shield member 392 on the PCB is not limited thereto. Meanwhile, the first bonding member and the second bonding member may be individually formed but may also be integrally formed as one to correspond to at least a portion of the entire shape or the entire shape of the shield can assembly mounted on the PCB.

In an embodiment, the upper flange 3923 may be formed in the upper end of the second side surface part 3921, for example, at least a portion of the end of the second side surface part 3921 opposite to the first board surface. In an embodiment, the upper flange 3923 may protrude in a direction that is substantially perpendicular to the height direction h of the second side surface part 3921. In an embodiment, the upper flange 3923 may be disposed on a connecting part of the first portion 392A and the second portion 392B, for example, a portion in which the second shield member is bent. In an embodiment, the upper flange 3923 may perform the function of supporting a shield cover (e.g., the shield cover 380 of FIG. 3B).

In an embodiment, the second support part 3922 or the upper flange 3923 may be formed on the upper end of the second support part 3922. As shown in FIG. 3B, while the second shield member is connected to the first board surface, the second support part 3922 and the upper flange 3923 may extend toward the inside of the shield area. In this case, a third width W3 in which the second support part 3922 extends from the second side surface part 3921 may be less than a fourth width W4 in which the lower flange 3913 extends from the second side surface part 3921.

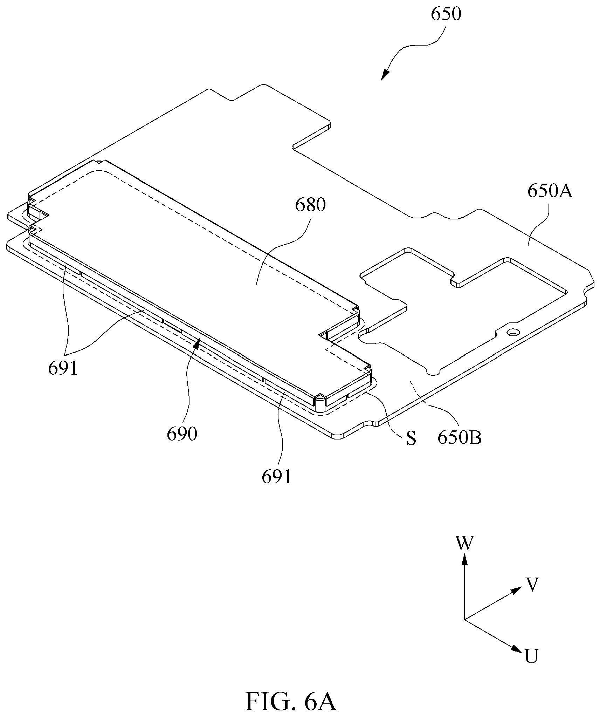

FIG. 6A is a perspective view of a PCB to which a shield can assembly is connected according to an embodiment.

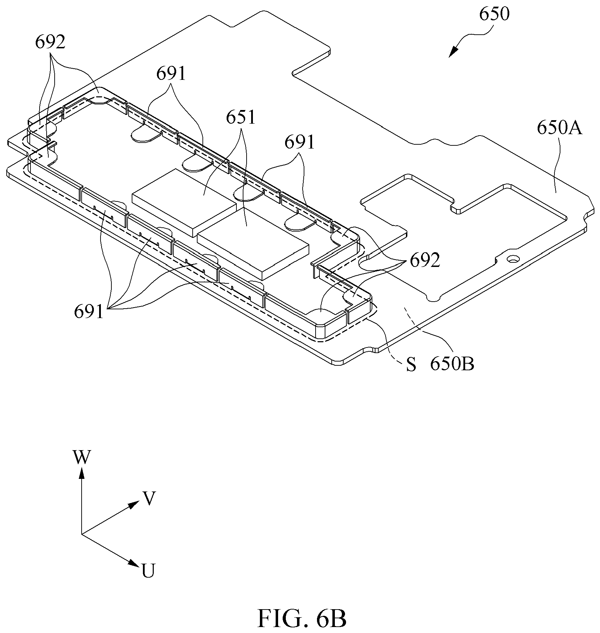

FIG. 6B is a perspective view of a PCB to which a shield can assembly is connected in a state in which a shield cover is removed from FIG. 6A, according to an embodiment. Referring to FIGS. 6A and 6B, in an embodiment, a shield can assembly 690 may be disposed on a surface of a PCB 650. In an embodiment, the PCB 650 may include a first board surface 650A and a second board surface 650B that is opposite to the first board surface 650A. In an embodiment, at least one electrical component 651 may be disposed on the first board surface 650A of the PCB 650. In an embodiment, the shield can assembly 690 may form the shield area S while enclosing the at least one electrical component 651.

In an embodiment, the shield can assembly 690 may include a plurality of unit shield members 691 and 692 and a shield cover 680. The plurality of unit shield members 691 and 692 may be continuously disposed along the edge of the shield area S and may enclose the shield area S in a closed-loop shape. In an embodiment, the plurality of unit shield members 691 and 692 may include a plurality of first shield members 691 enclosing the shield area S by a straight shape and a plurality of second shield members 692 enclosing the shield area S by a curved shape, for example, enclosing the edge part of the shield area S. In an embodiment, the plurality of first shield members 691 may be formed as the same shape and the plurality of second shield members 692 may be formed as the same shape. In an embodiment, the shield cover 680 may be formed as a shape that substantially corresponds to the shape of the shield area S. For example, the shield cover 680 may overlap the entire shield area S while viewing the first board surface 650A.

In an embodiment, the plurality of first shield members 691 and the plurality of second shield members 692 may be selectively disposed on the edge of the shield area S along the design shape of the shield area S to enclose the circumference of the shield area S in a closed-loop shape. By the above structure, since the shield area S having various shapes may be covered by changing the number and arrangement of the standardized unit shield members 691 and 692, high versatility may be ensured.

According to an embodiment of the disclosure, an electronic device (101; 202) comprising: a housing (210) including a front surface (210a), a rear surface (210b) that is opposite to the front surface, and a side surface (210c) enclosing an internal space between the front surface (210a) and the rear surface (210b); a display (261) visually exposed to an outside through the front surface (210a); a printed circuit board (PCB)(300) disposed in the internal space and comprising a first board surface (300A) and a second board surface 300B that is opposite to the first board surface (300A), and comprises a shield area (S) in which at least one electrical component (351) on the shield area of the board surface; and a shield can assembly (390) disposed along a circumference of the shield area (S) and connected to the PCB (300), the shield can assembly (390) forming a partition wall (3900) substantially perpendicular to the first board surface (300A). In an embodiment, the shield can assembly (390) comprises: while viewing the first board surface (300A), at least one first shield member (391) extending in a longitudinal direction (L1); a plurality of second shield members (392) comprising a first portion (392A) in a longitudinal direction (L2) and a second portion (392B) in a longitudinal direction (L3) that is substantially perpendicular to the first portion (392A); and a shield cover (380) connected to the first shield member (391) and the second shield member (392) to covering the shield area (S). In an embodiment, the at least one shield members (391) and the plurality of second shield members (392) are disposed to enclose at least a portion of the shield area (S).

According to an embodiment, while viewing the first board surface (300A), the first shield member (391) and the second shield member (392) are formed to open at least a portion of the shield area (S). In an embodiment, a shape of the shield cover (380) substantially corresponds to a shape of the shield area (S). In an embodiment, the shield cover (380) is connected to the first shield member (391) and the second shield member (392) to cover the open part of the shield area (S).

According to an embodiment, based on a cross-section perpendicular to the first board surface (300A), a first side surface part (3911) extending from the first board surface (300A) in a height direction (h) that is substantially perpendicular to the first board surface (300A) and forming at least a portion of the partition wall (3900); and a first support part (3912) extending in a direction substantially perpendicular to the height direction (h) from an end of the first side surface part (3911) opposite to the first board surface (300A).

According to an embodiment, the first shield member (391) further comprises at least one lower flange (3913) formed in a portion of the first side surface part (3911) and extending in a direction that is substantially perpendicular to the height direction (h) from an end of the first side surface part (3911) adjacent to the first board surface (300A).

According to an embodiment, the first support part (3912) and the lower flange (3913) extend toward the shield area (S).

According to an embodiment, the second shield member (392) comprises: based on a cross-section perpendicular to the first board surface (300A), a second side surface part (3921) extending from the first board surface (300A) in the direction (h) substantially perpendicular to the first board surface 300A and forming at least a portion of the partition wall (3900); and a second support part (3922) extending from an end of the second side surface part (3921) opposite to the first board surface (300A) in a direction substantially perpendicular to the height direction (h).

According to an embodiment, the second shield member (392) further comprises: an upper flange (3923) formed on a portion of the second side surface part (3921) and protruding in the direction substantially perpendicular to the height direction (h) from the end of the second side surface part (3921) opposite to the first board surface (300A).

According to an embodiment, the upper flange (3923) is disposed on a connecting part of the first portion (392A) and the second portion (392B).

According to an embodiment, while viewing the first board surface (300A), a length of the first portion (392A) is different than a length of the second portion (392B).

According to an embodiment, a gap (G) exists between the first shield member (391) and the second shield member (392) that are adjacent to each other or between adjacent second shield members (392).

According to an embodiment, the PCB (300, 600) further comprises a circuit wiring (352) formed on the first board surface (300A) and extending from the shield area (S) to an outside of the shield area (S) through the gap (G).

According to an embodiment, the at least one first shield member (391) and the plurality of second shield members (392) enclose the shield area (S) in a closed-loop shape.

According to an embodiment, the electronic device further comprising a bonding member (393) connected to the shield can assembly (390) and configured to seal the gap (G).

According to an embodiment, the shield cover (380) comprises: a first cover portion (381) disposed substantially parallel with the first board surface (300A); and a second cover portion (382) connected to an edge of the first cover portion (381) and connected to an outer circumferential surface of the partition wall (3900).

According to an embodiment, the partition wall (3900) may have a thickness of 0.15mm or less, based on the height direction.

According to an embodiment of the disclosure, A shield can assembly (390) may be connected to a printed circuit board (PCB) (300; 650), the shield can assembly comprising: while viewing a surface (300A; 650A) of the PCB (300; 600), at least one first shield member (391; 691) having a substantially straight shape; and a plurality of second shield members (392; 692) comprising a first portion (392A) extending in a longitudinal direction (L2) and a second portion (392B) extending from an end of the first portion (392A) in a longitudinal direction (L3) that is substantially perpendicular to the first portion (392A). In an embodiment, the at least one first shield member (391; 691) and the plurality of second shield members (392; 692) are disposed to enclose a shield area of the PCB (300; 650) in a closed-loop shape.

According to an embodiment, the first shield member (391) comprises: a first side surface part (3911) perpendicular to a surface (300A) of the PCB (300); and a first support part (3912) bent in a direction parallel with the surface (300A) of the PCB from an end of the first side surface part (3911) that is opposite to the surface (300A) of the PCB. In an embodiment, the second shield member (392) comprises: a second side surface part (3921) perpendicular to the surface (300A) of the PCB; and a second support part (3922) bent in the direction parallel with the surface (300A) of the PCB from an end of the second side surface part (3921) that is opposite to the surface of the PCB. In an embodiment, an edge of a shield cover (380) for covering the shield area is connected to the first support part (3911) and the second support part (3921).

According to an embodiment, the first shield member (391) further comprises a lower flange (3913) connected to at least a portion of the first side surface part (3911) and contacts the surface (300A) of the PCB. In an embodiment, the lower flange (3913) is substantially formed on a central part of the first shield member (391) while viewing the surface (300A) of the PCB.

According to an embodiment, the second shield member (392) further comprises an upper flange (3923) connected to the second side surface part 3921 and spaced apart from the surface (300A) of the PCB. In an embodiment, the upper flange (3923) is formed in a connecting part of the first portion (392A) and the second portion (392B) while viewing the surface (300A) of the PCB.

According to an embodiment of the disclosure, an electronic device (101;201) comprising: a housing (210) including a front surface (210a), a rear surface (210b) opposite to the front surface (210a), and a side surface (210c) enclosing an internal space between the front surface (210a) and the rear surface (210b); a display (261) disposed on the front surface (210a); a printed circuit board (PCB) (300; 650) disposed in the internal space and comprising at least one electrical component (351; 651) disposed on a surface thereof; and a shield can assembly (390) connected to the PCB (300; 650), the shield can assembly forming a shield area on the PCB and enclosing the electrical component (351; 651). In an embodiment, the shield can assembly (390) comprises: while viewing a surface (300A) of the PCB, a first shield member (391) and a second shield member (392) disposed along the shield area (S) to form a closed-loop and forming a partition wall (3900) perpendicular to the surface of the PCB; and a shield cover (380) that is connected to the first shield member (391) and the second shield member (392) and covering a surface part of the PCB positioned in the shield area (S) while viewing the surface (300A) of the PCB. In an embodiment, the first shield member (391) comprises a first side surface part (3911) forming at least a portion of the partition wall (3900) and has a substantially straight shape while viewing the surface (300A) of the PCB. In an embodiment, the second shield member (392) comprises a first portion (392A) and a second portion (392B) having longitudinal directions (L2) and (L3) that are perpendicular to each other while viewing the surface of the PCB and an upper flange (3923) that is formed on ends of the first portion and the second portion opposite to the surface (300A) of the PCB and is configured to connect to the shield cover (380).

## Claims

1. An electronic device (101;201) comprising:
a housing (210) comprising:
a front surface (210a),
a rear surface (210b) that is opposite to the front surface, and
a side surface (210c) enclosing an internal space between the front surface (210a) and the rear surface (210b);
a display (261) visually exposed to an outside through the front surface (210a);
a printed circuit board (PCB)(300) disposed in the internal space and comprising a first board surface (300A) and a second board surface 300B that is opposite to the first board surface (300A), and comprises a shield area (S) in which at least one electrical component (351) on the shield area of the board surface; and
a shield can assembly (390) disposed along a circumference of the shield area (S) and connected to the PCB (300), the shield can assembly (390) forming a partition wall (3900) substantially perpendicular to the first board surface (300A),
wherein the shield can assembly (390) comprises:
while viewing the first board surface (300A),
at least one first shield member (391) extending in a longitudinal direction (L1);
a plurality of second shield members (392) comprising:
a first portion (392A) in a longitudinal direction (L2) and
a second portion (392B) in a longitudinal direction (L3) that is substantially perpendicular to the first portion (392A); and
a shield cover (380) connected to the first shield member (391) and the second shield member (392) to covering the shield area (S),
wherein the at least one shield members (391) and the plurality of second shield members (392) are disposed to enclose at least a portion of the shield area (S).

2. The electronic device of claim 1, wherein, while viewing the first board surface (300A), the first shield member (391) and the second shield member (392) are formed to open at least a portion of the shield area (S), andwherein a shape of the shield cover (380) substantially corresponds to a shape of the shield area (S) and the shield cover (380) is connected to the first shield member (391) and the second shield member (392) to cover the open part of the shield area (S).

3. The electronic device of one of claims 1 and 2, wherein the first shield member (391) comprises:
based on a cross-section perpendicular to the first board surface (300A),
a first side surface part (3911) extending from the first board surface (300A) in a height direction (h) that is substantially perpendicular to the first board surface (300A) and forming at least a portion of the partition wall (3900); and
a first support part (3912) extending in a direction substantially perpendicular to the height direction (h) from an end of the first side surface part (3911) opposite to the first board surface (300A).

4. The electronic device of one of claims 1 to 3, wherein the first shield member (391) further comprises at least one lower flange (3913) formed in a portion of the first side surface part (3911) and extending in a direction that is substantially perpendicular to the height direction (h) from an end of the first side surface part (3911) adjacent to the first board surface (300A).

5. The electronic device of one of claims 1 to 4, wherein the first support part (3912) and the lower flange (3913) extend toward the shield area (S).

6. The electronic device of one of claims 1 to 5, wherein the second shield member (392) comprises:
based on a cross-section perpendicular to the first board surface (300A),
a second side surface part (3921) extending from the first board surface (300A) in the direction (h) substantially perpendicular to the first board surface 300A and forming at least a portion of the partition wall (3900); and
a second support part (3922) extending from an end of the second side surface part (3921) opposite to the first board surface (300A) in a direction substantially perpendicular to the height direction (h).

7. The electronic device of one of claims 1 to 6, wherein the second shield member (392) further comprises:
an upper flange (3923) formed on a portion of the second side surface part (3921) and protruding in the direction substantially perpendicular to the height direction (h) from the end of the second side surface part (3921) opposite to the first board surface (300A).

8. The electronic device of one of claims 1 to 7, wherein the upper flange (3923) is disposed on a connecting part of the first portion (392A) and the second portion (392B).

9. The electronic device of one of claims 1 to 8, wherein, while viewing the first board surface (300A), a length of the first portion (392A) is different than a length of the second portion (392B).

10. The electronic device of one of claims 1 to 9, wherein a gap (G) exists between the first shield member (391) and the second shield member (392) that are adjacent to each other or between adjacent second shield members (392).

11. The electronic device of one of claims 1 to 10, wherein the PCB (300, 600) further comprises a circuit wiring (352) formed on the first board surface (300A) and extending from the shield area (S) to an outside of the shield area (S) through the gap (G).

12. The electronic device of one of claims 1 to 11, wherein, while viewing the first board surface (300A), a width of the gap (G) is less than or equal to 0.1 mm.

13. The electronic device of one of claims 1 to 12, further comprising a bonding member (393) connected to the shield can assembly (390) and configured to seal the gap (G).

14. The electronic device of one of claims 1 to 13, wherein the shield cover (380) comprises:
a first cover portion (381) disposed substantially parallel with the first board surface (300A); and
a second cover portion (382) connected to an edge of the first cover portion (381) and connected to an outer circumferential surface of the partition wall (3900).

15. The electronic device of one of claims 1 to 14, wherein the at least one first shield member (391) and the plurality of second shield members (392) enclose the shield area (S) in a closed-loop shape.
